# EUROPÄISCHE PATENTSCHRIFT

(11) **EP 0 892 823 B1**
(45) Veröffentlichungstag und Bekanntmachung des Hinweises auf die Patenterteilung: **12.01.2000**
(21) Anmeldenummer: 97915482.0
(22) Anmeldetag: 04.04.1997
(51) Int. Cl.: C08G 65/22, C08G 65/16, G03F 7/039, G03C 9/08, G03F 7/004

(54) **POLYMERE VON 2,7-DIOXA-BICYCLO 3.2.1]OCTANDERIVATEN**
POLYMERS OR 2,7-DIOXA-BICYCLO 3,2,1]OCTANE DERIVATIVES
POLYMERES DE DERIVES DE 2,7-DIOXA-BICYCLO 3.2.1]OCTANE

(30) Priorität: 13.04.1996 DE 19614635
(43) Veröffentlichungstag der Anmeldung: 27.01.1999
(73) Patentinhaber: BASF AKTIENGESELLSCHAFT, 67056 Ludwigshafen (DE)
(72) Erfinder: REICH, Wolfgang, D-67133 Maxdorf (DE); SCHWALM, Reinhold, D-67157 Wachenheim (DE); HÄUSSLING, Lukas,, 59457 Werl Westönnen (DE); NUYKEN, Oskar, D-81927 München (DE); RAETHER, Roman-Benedikt,, Austin, TX 78731-3169 (US)
(86) Internationale Anmeldenummer: EP9701689
(87) Internationale Veröffentlichungsnummer: WO9739047

(56) Entgegenhaltungen:
- MACROMOLECULES, Bd. 21, Nr. 06, 1988, WASHINGTON D.C. USA, Seiten 1566-1579, XP002034997 HIRASAWA T. ET AL: "Polymerisation of bicyclic acetals."
- DIE MAKROMOLEKULARE CHEMIE , MACROMOL. SYMPOS., Nr. 6, 1986, BASEL ,SCHWEIZ, Seiten 11-21, XP002034998 SUMITOMO H. ET AL: "Sterically controlled cationic propagation in the ring-opening polymerisation of bicyclic acetals"
- CHEMICAL ABSTRACTS, vol. 97, no. 25, 20.Dezember 1982 Columbus, Ohio, US; abstract no. 216139c, OAKES F. ET AL: "The synthesis of 2,7-dioxabicyclo(3.2.1)octanes." Seite 850; XP002034999 & SYNTH. COMMUN., Bd. 12, Nr. 8, 1982, F. OAKES ET AL:

## Beschreibung

Die Erfindung betrifft Polymerisate, erhältlich durch Polymerisation bzw. Copolymerisation von 2,7-Dioxa-bicyclo[3.2.1]octan-derivaten der Formel 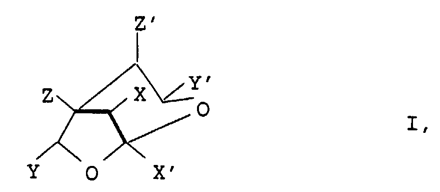 worin X, X', Y, Y', Z und Z' unabhängig voneinander für einen C₁-C₂. Kohlenwasserstoffrest oder ein H-Atom stehen.

Weiterhin betrifft die Erfindung die Verwendung der Polymerisate zur Herstellung von Beschichtungen und Formkörpern, insbesondere auch strukturierten Beschichtungen und Formkörpern.

Die Herstellung von Beschichtungen und Formkörpern durch Strahlungshärtung von radikalisch oder kationisch polymerisierbaren Verbindungen ist allgemein bekannt. Besondere technische Bedeutung hat die Strahlungshärtung von Acrylatverbindungen erlangt. Bei Acrylatverbindungen besteht jedoch grundsätzlich das Problem, daß die Photopolymerisation durch Sauerstoff inhibiert wird.

Gesucht sind daher insbesondere kationisch polymerisierbare Monomere, welche sich zur Herstellung von Beschichtungen und Formkörpern eignen.

Technisch von Bedeutung sind auch strukturierte Beschichtungen und Formkörpern, z.B. Leiterplatten, Druckplatten etc.

Zur Herstellung solcher strukturierten Systeme verwendet man insbesondere sog. Photoresiste, das sind Lacke, die durch Bestrahlung mit energiereichem Licht ihre Löslichkeit ändern. Durch gezielte Bestrahlung und anschließendes Entfernen der durch die Bestrahlung löslich gewordenen Verbindungen werden Strukturen hergestellt.

Gesucht sind daher auch Polymerisate, welche sich als Photoresiste eignen.

Aufgabe der Erfindung waren Polymerisate, welche sich zur Herstellung von Beschichtungen und Formkörpern durch Strahlungshärtung eignen.

Demgemäß wurde die oben definierten Polymerisate gefunden. Ebenso wurden Verfahren zur Herstellung der Polymerisate und Verwendungen der Polymerisate gefunden.

Die erfindungsgemäßen Polymerisate enthalten vorzugsweise 0,05 bis 100 Gew.-%, besonders bevorzugt 0,5 bis 100 Gew.-% und ganz besonders bevorzugt 1 bis 100 Gew.-% der Verbindungen der Formel I als Monomer bzw. Comonomer.

Besonders geeignet für Beschichtungen und Formkörper sind auch Polymerisate mit einem Gehalt von 10 bis 100 Gew.-%, 30 bis 100 Gew.-%, 50 bis 100 Gew.-% oder 80 bis 100 Gew.-% der Verbindungen der Formel I.

Bevorzugte Verbindungen der Formel I sind solche, in denen X, X', Y, Y', Z, Z' unabhängig voneinander für ein H-Atom, eine C₁-C₈-insbesondere eine C₁-C₄-Alkylgruppe oder eine Phenylgruppe stehen.

Besonders bevorzugt stehen mindestens 4 der Reste X, X', Y, Y', Z und Z' für ein H-Atom.

Ganz besonders bevorzugt stehen alle Reste für ein H-Atom, d.h. es handelt sich um 2,7-Dioxa-bicyclo[3,2,1]octan der Formel 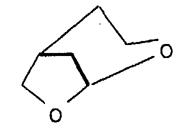 2,7-Dioxa-bicyclo[3.2.1]octan und dessen Derivate können durch ein Verfahren hergestellt werden, welches dadurch gekennzeichnet ist, daß
a) ein Butendiolderivat an einen Vinylether in Gegenwart eines Halogenierungsmittels gemäß 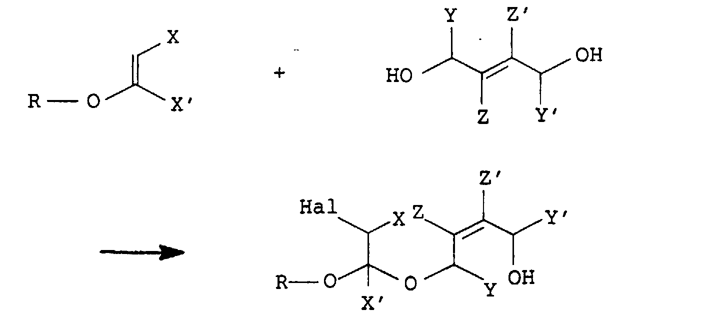 addiert wird, wobei R für einen Kohlenwasserstoffrest, Hal für einen Halogenatom und X,X', Y, Y', Z und Z' unabhängig voneinander für ein H-Atom oder einen C₁-C₂₀-Kohlenwasserstoffrest stehen,
b) im 2. Verfahrensschritt der Tetrahydrofuranring geschlossen wird, gemäß 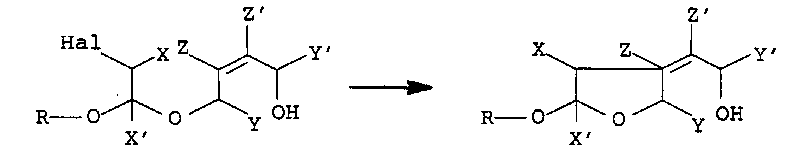
c) danach der Alkohol ROH eliminiert wird, gemäß 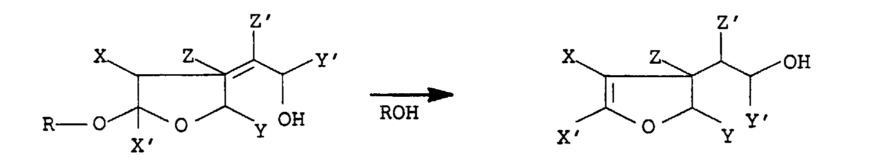
d) und der Ringschluß zum 2,7-Dioxa-bicyclo[3,2,1]octan bzw. dessen Derivat erfolgt, gemäß 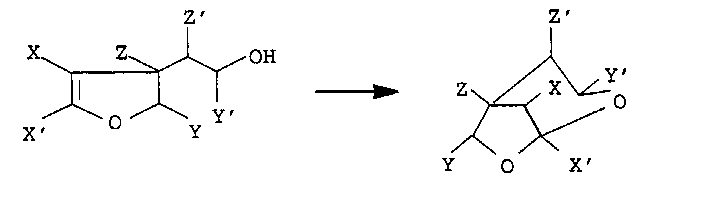 Die nachfolgenden Angaben betreffen bevorzugte Ausführungsformen des Verfahrens.

In Verfahrensschritt a) erfolgt die Umsetzung eines Vinylethers, insbesondere eines Alkylvinylethers, mit einem But-2-en-1,4-diol gemäß 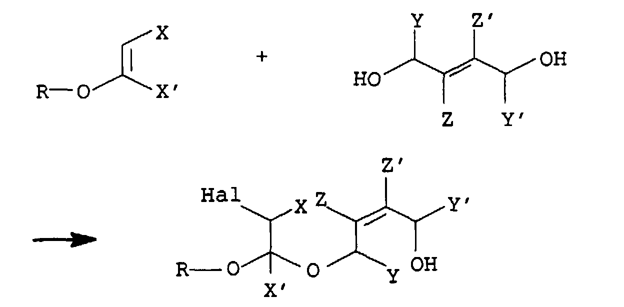 wobei Hal für ein Halogenatom, R für einen Kohlenwasserstoffrest, insbesondere einen Alkylrest, vorzugsweise einen C₁-C₂₀-Alkylrest und X, X', Y, Y', Z und Z' unabhängig voneinander für einen C₁-C₂₀-Kohlenwasserstoffrest oder ein H-Atom stehen.

Bevorzugt steht Hal für ein Bromatom und R für einen C₁-C₈-, insbesondere C₁-C₄-, ganz besonders bevorzugt für eine C₂-Alkylgruppe X, X', Y, Y', Z und Z' stehen bevorzugt unabhängig voneinander für ein H-Atom oder eine C₁-C₈-, insbesondere eine C₁-C₄-Alkylgruppe, oder eine Phenylgruppe.

Besonders bevorzugt stehen mindestens 4 der Reste X. X', Y, Y', Z und Z' für ein H-Atom. Ganz besonders bevorzugt stehend alle Reste X, X', Y, Y', Z, Z' für ein H-Atom.

Verfahrensschritt a) wird bevorzugt in Gegenwart einer Halogenierungs-, z.B. Bromierungsmittel, insbesondere von N-Bromsuccinimid durchgeführt.

Der Vinylether und das But-2-en-1,4-diol-derivat werden vorzugsweise in equimolaren Mengen eingesetzt. Das Halogenierungsmittel wird vorzugsweise im molaren Überschuß, insbesondere von 1,01 bis 1,5 Mol zu 1 Mol Vinylether verwendet.

Die Temperatur beträgt bei der Umsetzung im allgemeinen zwischen 0 und -30°C, insbesondere -10 bis -25°C.

Das Endprodukt (ein β-Halogenacetal bzw. β-Bromacetal) wird in hohen Ausbeuten von insbesondere über 70 % der Theorie erhalten.

In Verfahrensschritt b) wird der Tetrahydrofuranring geschlossen gemäß

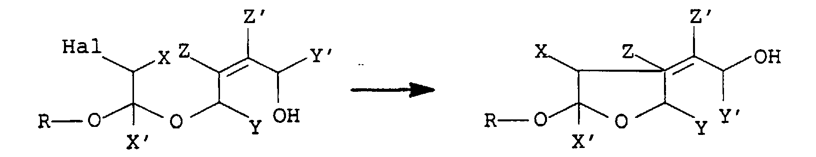

Der Ringschluß erfolgt bevorzugt durch Radikalkettenreaktion Hal steht bevorzugt für Brom oder Chlor, insbesondere für Brom.

Die Reaktion wird bevorzugt in Gegenwart von Zinnhydriden, z.B. Tributylzinnhydrid (Tributylstannan, Bu₃SnH) durchgeführt.

Das Halogenacetal und Tributylzinnhydrid wird dazu vorzugsweise in equimolaren Mengen eingesetzt.

Die Reaktion wird bevorzugt in Gegenwart von Radikalbildnern, z.B. Azodiisobutyronitril oder Peroxiden durchgeführt, wobei die Radikalbildner im Unterschuß, vorzugsweise in Mengen von 1 bis 30, insbesondere 5 bis 20 mol-%, bezogen auf Halogenacetal, eingesetzt werden.

Die Reaktion verläuft exotherm, daher ist im allgemeinen lediglich ein kurzes Erhitzen zu Anfang erforderlich, um die Reaktion in Gang zu bringen.

In Verfahrensschritt c) entsteht unter Eliminierung des Alkohols (R-OH) 3Hydroxyethyl-2,3-dihydrofuran gemäß

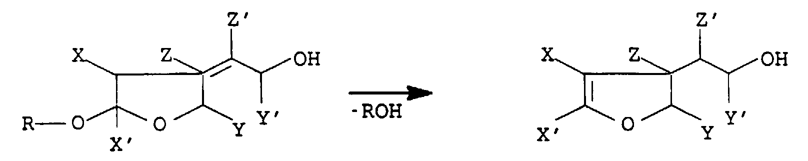

Anschließend erfolgt bevorzugt durch saure Katalyse der Ringschluß gemäß Verfahrensschritt d): 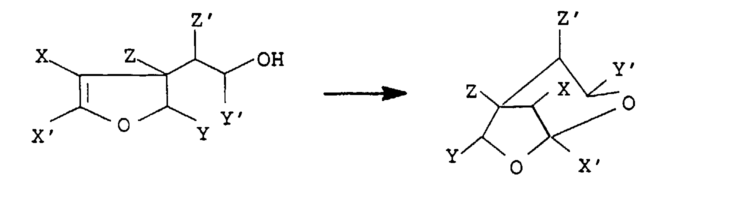 insbesondere 5 bis 20 mol-%, bezogen auf Halogenacetal, eingesetzt werden.

Verfahrensschritt c) ist eine an sich bekannte Eliminierungsreaktion, welche bevorzugt in Gegenwart starker Säuren, z.B. Phosphorpentoxid durchgeführt wird.

Gleichzeitig wird unter sauren Bedingungen der Ringschluß zum 2,7-Dioxa-bicyclo[3,2,1]octan katalysiert.

Die erfindungsgemäßen Polymerisate können neben den Verbindungen der Formel I noch weitere Monomere als Aufbaukomponenten enthalten,

Zum Beispiel kommen als weitere kationisch polymerisierbare Verbindungen insbesondere lineare oder cyclische Vinylether, z.B. Vinylmethylether, Vinylethylether, Vinylpropylether, Vinylisobutylether, Vinyloctadecylether, Vinylcyclohexylether, α-substituierte Vinylether, wie sie in der deutschen Patentanmeldung P 19600342.3 oder 2,3-Dihydrofurane, wie sie z.B. in der deutschen Patentanmeldung 19610349 (O.Z. 46665) aufgeführt sind.

Ebenso kommen als weitere kationisch polymerisierbare Verbindungen auch Epoxide, z.B. Cyclopentenoxid, Cyclohexenoxid, epoxidiertes Polybutadien, epoxidiertes Sojabohnenöl, Degacure K 126 (cyclisches Diepoxid) oder Glycidylether, z.B. Butandioldiclycidether, Hexandioldiglycidether, z.B. Biphenol-A-Diglycidether, Pentaerythrittriglycidylether in Betracht.

Mitverwendet werden können auch kationisch polymerisierbare Monomere, wie ungesättigte Aldehyde und Ketone, Diene wie Butandien, Vinylaromaten wie Styrol, N-substituierte Vinylamine wie Vinylcarbazol, cyclische Ether, wie Tetrahydrofuran.

Die erfindungsgemäßen Polymerisate können durch kationische Polymerisation der Verbindungen der Formel I und gegebenenfalls weiteren Verbindungen hergestellt werden.

Die Durchführung der kationischen Polymerisation ist dem Fachmann bekannt.

Als Initiatoren für die kationische Polymerisation sind im allgemeinen Lewis-Säuren geeignet, z.B. Komplexe aus BF₃, AlCl₃, TiCl₄, SnCl₄ mit Wasser oder Alkohol, wobei solche Säuren geeignet sind, die keine Protonen abgeben. Brönstedt-Säuren sind daher nicht bevorzugt.

Die Polymerisationstemperatur beträgt vorzugsweise -78 bis +30°C.

Bei der kationischen Polymerisation der Verbindungen der Formel I bleibt überraschenderweise der 6-Ring erhalten. Unter Öffnung des 5-Rings enthält das erhaltene-Polymerisat dann folgende Struktureinheiten:

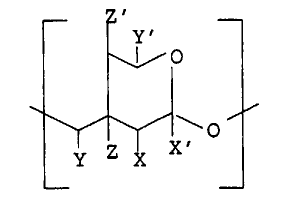

Die kationische Polymerisation kann vorzugsweise photochemisch initiiert werden, d.h. die Herstellung des Polymerisats erfolgt durch Strahlungshärtung. Dazu wird den zu polymerisierenden Verbindungen ein Initiator für die kationische Photopolymerisation zugesetzt.

Photoinitiatoren für die kationische Photopolymerisation liefern bei Bestrahlung mit UV-Licht Säuren, genannt seinen z.B. Aryldiazonium-, Aryliodonium- oder Arylsulfoniumsalze, Disulfone, Diazodisulfone, Imido-triflate, Benzointosylate folgender Strukturen:

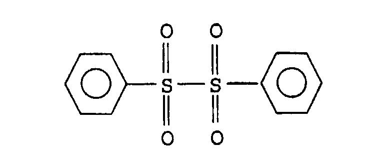

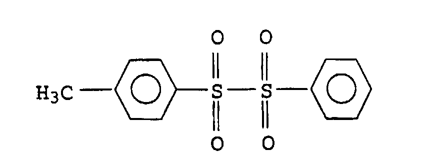

Beispielhaft seien weiterhin p-Methoxybenzoldiazoniumhexafluorophosphat, Benzoldiazoniumtetrafluoroborat, Toluoldiazoniumtetrafluoroarsenat, Diphenyliodoniumhexafluoroarsenat, Triphenylsulfoniumhexafluorophosphat, Benzolsulfoniumhexafluorophosphat, Toluolsulfoniumhexafluorophosphat oder Degacure KI85 (Bis[4-diphenylsulfonio-phenyl]sulfid-bis-hexafluorophosphat), Isochinoliniumsalze, Phenylpyridiniumsalze oder Picoliniumsalze, wie z.B. M-Ethoxy-isochinoliniumhexafluorophosphat, N-Ethoxy-4-phenylpyridiniumhexafluorophosphat oder N-Ethoxy-2-picoliniumhexafluorophosphat genannt. Auch Ferroceniumsalze (z.B. Irgacure 261 von Ciba) oder Titanocene sind geeignet.

Für die kationische Photopolymerisation der erfindungsgemäßen Polymerisate sind insbesondere Photoinitiatoren geeignet, die keine Brönsted-Säuren freisetzen, d.h. keine Protonen-Säuren.

Als besonders geeignete Photoinitiatoren genannt seien z.B. Ferroceniumsalze wie Irgacure 261.

Die erfindungsgemäßen Polymerisate werden insbesondere zur Herstellung von Beschichtungen und Formkörpern verwendet.

Dazu können die zu polymerisierenden Verbindungen gegebenenfalls zusammen mit für die jeweilige Verwendung üblichen Zusatzstoffen (zusammenfassend strahlungshärtbare Massen genannt) auf die zu beschichtenden Substrate aufgebracht bzw. in die gewünschte Form gebracht und anschließend durch Bestrahlung mit energiereichem Licht gehärtet werden.

Bei den Zusatzstoffen handelt es sich z.B. um die vorstehend genannten Photoinitiatoren, welche vorzugsweise in einer Menge von 0,5 bis 5 Gew.-%, bezogen auf die kationisch zu polymerisierenden Verbindungen, verwendet werden, weitere Zusatzstoffe sind z.B. Verlaufsmittel, Verstärker, Pigmente oder Füllstoffe.

Die Strahlungshärtung erfolgt vorzugsweise mit UV-Licht. Geeignet sind dazu z.B. UV-Strahler mit einem Wellenlängenbereich von 240 bis 400 nm und einer Leistung von 50 bis 240 W/cm.

Besonders bevorzugt eignen sich die strahlungshärtbaren Massen zur Herstellung von Beschichtungen auf Holz, Kunststoff, Papier, Metall, wobei sie durch Elektronenstrahlen oder nach Zusatz von Photoinitiatoren durch UV Strahlung vernetzt, d.h. gehärtet werden und Beschichtungen ergeben, die den Anforderungen an Schutzüberzüge oder dekorative Überzuge gerecht werden.

Die strahlungshärtbaren Massen haben eine hohe Reaktivität, d.h. hohe Härtungsgeschwindigkeit bei der Strahlungshärtung.

Insbesondere eignen sich die erfindungsgemäßen Polymerisate auch zur Herstellung strukturierter Beschichtungen und Formkörper.

Die erfindungsgemäßen Polymerisate lassen sich leicht depolymerisieren, wobei wieder die Ausgangsverbindungen, d.h. die Verbindungen der Formel I erhalten werden.

Die Depolymerisierung kann photochemisch, z.B. durch UV-Licht initiiert werden. Bevorzugt wird dem Polymerisat dazu ein Photoinitiator zugesetzt.

Es handelt sich dabei vorzugsweise um einen Photoinitiator, der eine Brönsted-Säure freisetzt, also eine Protonen-Säure, z.B. N-Ethoxy-2-picolinium-hexafluorophosphat oder Aryliodonium bzw. Arylsulfoniumsalze.

Die Depolymerisation kann vorzugsweise bei Temperaturen von -30 bis +50°C, besonders bevorzugt bei 0 bis 30° bzw. bei Raumtemperatur von 15 bis 25°C durchgeführt werden.

Zur Herstellung von strukturierten Beschichtungen oder Formkörpern kann man daher zunächst, z.B. durch Strahlungshärtung, Beschichtungen und Formkörper herstellen, die zumindest zum Teil aus den erfindungsgemäßen Polymerisaten bestehen. Anschließend kann durch Depolymerisierung , z.B. von Teilen des Polymerisats (nicht zu depolymerisierende Teile können z.B. abgedeckt und so vor energiereicher Strahlung geschützt werden) und anschließende Entfernung der depolymerisierten Verbindungen eine Strukturierung erzeugt werden.

Die erfindungsgemäßen Polymerisate eignen sich daher auch als Photoresiste und insbesondere für Verwendungen in der Stereolithographie, zur Herstellung von Bauteilen für die Mikroelektronik, z.B. Mikroprozessoren oder zur Herstellung von Mikroformkörpern mit einem maximalen Durchmessern von z.B. unter 1 mm.

### Beispiele

### Herstellung von 2,7-Dioxa-bicyclo[3,2,1]octan

### Verfahrensschritt a): β-Bromoacetal

1 mol Ethylvinylether und 1 mol But-2-en-1,4-diol werden eingewogen und auf -20°C gekühlt. Unter Stickstoff werden 1,1 mol N-Bromsuccinimid zugegeben, und anschließend je 60 Minuten bei -20°C und Raumtemperatur gerührt. Die weiße Suspension wird mit 300 ml Wasser aufgeschlämmt und die organische Phase abgetrennt. Die wäßrige Phase wird mit Methylenchlorid ausgeschüttelt, und die vereinigten organischen Phasen mit 1 normale Natronlauge gewaschen, über Magnesiumsulfat getrocknet und schließlich das Lösungsmittel am Rotationsverdampfer abdestilliert.

Das Rohprodukt wird durch Vakuumdestillation gereinigt. Man erhält ein wasserklares Öl.
Ausbeute: 76 % d. Th.
Siedepunkt: 109°C bei 0,04 Torr
¹H-NMR (CDCl₃; ppm): 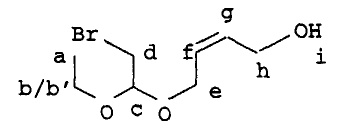 1,2 (a 3H); 2,2 (i 1H); 3,4 (d 2H); 3,6 und 3,7 (b und b' 2H); 4,2 (e und h 4H); 4,7 (c 1H); 5,6 bis 5,9 (f und g 2H)
¹³C-NMR (CDCl₃; ppm): 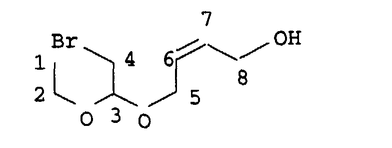 15 (1); 31 (4); 58 (8); 62 (2 Signale gerade noch aufgelöst (2 und 5); 101 (3); 128, 129, 131, 133 (6) und (7) cis und trans
IR (Film; cm⁻¹):
3418, 3026, 2976, 2881, 1423, 1374, 1346, 1187, 1122, 1036, 682 Verfahrensschritt b): 2-Ethoxy-4-(2-hydroxyethyl)tetrahydrofuran:

0,76 mol "β-Bromoacetal" werden mit einem Molprozent Azodiisobutyronitril in 300 ml absolutem Benzol vorgelegt. 0,76 mol Tributylzinnhydrid, in 200 ml Benzol gelöst, werden langsam zugetropft. Zu Beginn wird kurz erhitzt, bis die Reaktion anspringt. Die Reaktion verläuft dann unter kräftiger Wärmetönung.

Nach beendeter Zugabe rührt man so lange, bis die Wärmeentwicklung beendet ist (ca. eine Stunde). Dann wird der Ansatz 90 Minuten zum Sieden erhitzt.

Das Lösungsmittel wird am Rotationsverdampfer abdestilliert, und der Rückstand in Acetonitril aufgenommen, dann mit n-Hexan ausgeschüttelt.

Nach Einengen der Lösung am Rotationsverdampfer wird das Rohprodukt im Vakuum destilliert. (Ausbeute 65 % d. Th.

Zur weiteren Reinigung wird das Produkt mehrere Tage bei -25°C aufbewahrt, und dann rasch durch eine tiefgekühlte Fritte gesaugt. Anschließend erfolgt Reinigung durch Säulenchromatographie (Eluent: Essigsäureethylester/n-Hexan 1/1).
Ausbeute: 26 % d. Th.
Siedepunkt: 85°C bei 0,04 mbar
¹H-NMR (CDCl₃; ppm): 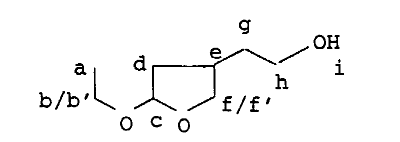 1,2 (a 3H); 1,4 bis 1,8 (d und g 4H); 1,9 (i 1H); 2,3 (e 1H); 3,4 bis 3,5 (b und b' 2H); 3,6 (h 2H); 3,8 und 4,0 (f und f 2H); 5,1 (c 1H)
¹³C-NMR (CDCl₃; ppm) : 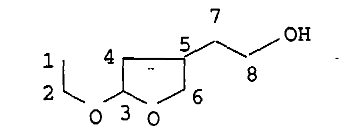 15 (1), 35 und 36 (4) und (7); 39 (5); 62 (8), 63 (2), 72 (6), 104 (3)
IR (Film; cm⁻¹):
3421, 2930, 2872, 1374, 1345, 1182, 1110, 1054
Verfahrensschritte c) und d): 2,7-Dioxabicyclo [3.2,1]octan:

44 mmol 2-Ethoxy-4-(2-hydroxyethyl)-tetrahydrofuran werden mit einer Spatelspitze Phosphorpentoxid versetzt, der Kolben sofort mit einer kurzen Destillationsbrücke verschlossen und in ein auf 80°C vorgeheiztes Ölbad getaucht. Das Vakuum wird auf 0,05 mbar eingestellt und die Vorlage mit flüssigem Stickstoff gekühlt.

Nach beendeter Destillation werden 20 ml 50 %ige Natronlauge in die Vorlage gegeben, und diese erst danach aus dem flüssigen Stickstoff genommen.

Nach dem Auftauen wird der Inhalt der Vorlage ausgeethert, und die organische Phase über Natriumcarbonat getrocknet, dann das Lösungsmittel im Vakuum abgezogen, Ausbeute: 68 % d. Th.
¹H-NMR (d₆-Aceton; ppm): 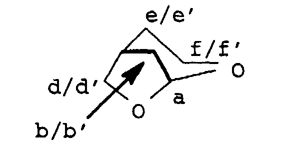 2,45 und 2,6 (b und b' 2H); 2,75 bis 2,9 (e und e'2H); 2,5 (c 1H); 3,6 und 4,0 (f und f' 2H); 4,75 bis 4,85 (d und d' 2H); 5,2 (a 1H)
¹³C-NMR (d₆-Aceton; ppm): 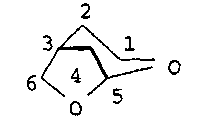 31 (2); 33 (3); 39 (4); 60 (1); 73 (6); 100 (5);
IR (Film; cm⁻¹):
2945, 2879, 1454, 1384, 1273, 1242, 1178, 1153, 1080, 1049, 1011, 995, 933, 908, 873, 826, 810, 759
Polymerisation von 2,7-Dioxabicyclo[3,2,1]octan

624 mg 2,7-Dioxabicyclo[3,2,1]octan (3 mol/l) und 7.7 mg Irgacure® 261 als Photoinitiator (10 mmol/l) werden in 2 ml Methylenchlorid gelöst, und 10 min mit UV-Licht bestrahlt.
Das Polymer wird durch Fällung aus n-Hexan gereinigt.
Spektroskopische Daten des Polymeren:
¹H-NMR (CDCl₃; ppm): 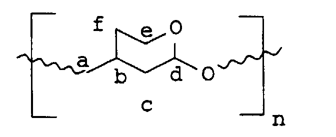 1,0 bis 2,0 (c und f 4H); 2,0 bis 2,7 (b 2 1H); 3,0 bis 4,2 (a und e 4H) ; 4,3 bis 5,2 (d 1H)
¹³C-NMR(CDCl₃; ppm) 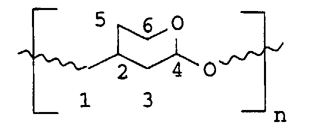 30 (3); 33 (2); 35 (5); 59 (6); 71 (1); 97 (4)
IR (Film; cm⁻¹:
2922, 1445, 1384, 1340, 1252, 1184, 1124, 1074, 1047, 989, 914, 860
Depolymerisation von Poly(2,7-Dioxabicyclo[3.2.1]octan)

10 mg Poly(2,7-Dioxabicyclo[3.2.1.]octan) (0,09 mmol Wiederholungseinheiten) und 0,009 mmol N-Ethoxy-2-picolinium-hexafluorophosphat (10 mol-%) werden in 2 ml feuchtem Methylenchlorid gelöst, und 10 min mit UV-Licht bestrahlt.

Der gesamte Küvetteninhalt wird in einen Kolben überführt und das Lösungsmittel am Rotationsverdampfer abdestilliert. Vom Rückstand wird ein ¹H-NMR-spektrum aufgenommen. Das Spektrum ist mit dem von 2,7-Dioxabicyclo[3.2.1.]octan (28) identisch.

## Patentansprüche

1. Polymerisate, erhältlich durch Polymerisation bzw. Copolymerisation von 2,7-Dioxa-bicyclo[3.2.1]octanderivaten der Formel 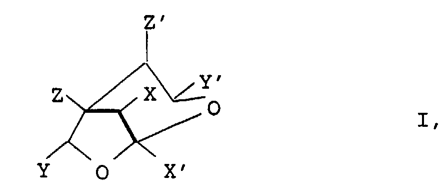 worin X, X', Y, Y', Z und Z' unabhängig voneinander für einen C₁-C₂₀ Kohlenwasserstoffrest oder ein H-Atom stehen.

2. Polymerisate gemäß Anspruch 1, enthaltend 0,05 bis 100 Gew.-% der Verbindungen der Formel I als Monomer bzw. Comonomer.

3. Polymerisate gemäß Anspruch 1 oder 2, wobei mindestens vier der Variablen X, X', Y, Y', Z und Z' in Formel I für ein H-Atom stehen.

4. Polymerisate gemäß einen der Ansprüche 1 bis 3, wobei alle Variablen X, X', Y, Y', Z und Z' für ein H-Atom stehen, es sich also um 2,7-Dioxa-bicyclo[3.2.1]octan handelt.

5. Verfahren zur Herstellung von Polymerisaten gemäß einem der Ansprüche 1 bis 4, dadurch gekennzeichnet, daß Verbindungen der Formel I kationisch polymerisiert werden.

6. Verfahren gemäß Anspruch 1, dadurch gekennzeichnet, daß die kationische Polymerisation photochemisch initiiert wird.

7. Verwendung von Polymerisaten gemäß einem der Ansprüche 1 bis 4 zur Herstellung von Beschichtungen und Formkörpern.

8. Beschichtungen und Formkörper, erhältlich unter Verwendung von Polymerisaten gemäß einem der Ansprüche 1 bis 4.

9. Verfahren zur Herstellung von strukturierten Beschichtungen oder Formkörpern, dadurch gekennzeichnet, daß die Beschichtungen und Formkörper zumindest zum Teil aus Polymerisaten gemäß einem der Ansprüche 1 bis 4 bestehen und eine Strukturierung durch Depolymerisation der Polymerisate erfolgt.

10. Verfahren gemäß Anspruch 9, dadurch gekennzeichnet, daß die Depolymerisierung durch energiereiches Licht in Gegenwart einer Brönstedt-Säure, d.h. einer Protonen abgebenden Säure, erfolgt.

11. Strukturierte Beschichtungen oder Formkörper, erhältlich unter Verwendung eines Polymerisats gemäß einem der Ansprüche 1 bis 4.

12. Verwendung von Polymerisaten gemäß einem der Ansprüche 1 bis 4 als Photoresist.

13. Verwendung von Polymerisaten gemäß einem der Ansprüche 1 bis 4 in der Stereolithographie.

14. Verwendung von Polymerisaten gemäß einem der Ansprüche 1 bis 4 zur Herstellung von Druckplatten.

15. Verwendung von Polymerisaten gemäß einem der Ansprüche 1 bis 4 zur Herstellung von Mikroformkörpern.

16. Verwendung von Polymerisaten gemäß einem der Ansprüche 1 bis 4 zur Herstellung von Bauteilen für die Mikroelektronik.

## Claims

1. A polymer obtainable by polymerizing or copolymerizing 2,7-dioxabicyclo[3.2.1]octane derivatives of the formula 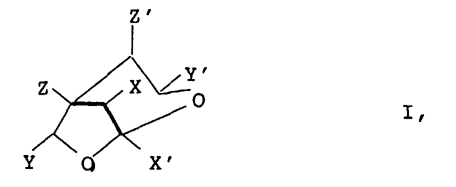 where X, X', Y, Y', Z and Z' each independently are a C₁-C₂₀ hydrocarbon radical or hydrogen.

2. A polymer as claimed in claim 1 containing from 0.05 to 100% by weight of compounds of the formula I as monomer or comonomer.

3. A polymer as claimed in claim 1 or 2, wherein at least four of X, X', Y, Y', Z and Z' in formula I are hydrogen.

4. A polymer as claimed in any of claims 1 to 3 wherein all of X, X', Y, Y' , Z and Z' are hydrogen and the compound is therefore 2,7-dioxabicyclo[3.2.1]octane.

5. A process for preparing a polymer as claimed in any of claims 1 to 4, which comprises subjecting compounds of the formula I to cationic polymerization.

6. A process as claimed in claim 5, wherein the cationic polymerization is initiated photochemically.

7. The use of a polymer as claimed in any of claims 1 to 4 for producing coatings or moldings.

8. A coating or molding obtainable using a polymer as claimed in any of claims 1 to 4.

9. A process for producing structured coatings or moldings, wherein the coatings or moldings consist at least in part of a polymer as claimed in any of claims 1 to 4 and structuring takes place by depolymerization.

10. A process as claimed in claim 9, wherein the depolymerization is effected by high-energy light in the presence of a Brönstedt acid, i.e. a proton-donating acid.

11. A structured coating or molding obtainable using a polymer as claimed in any of claims 1 to 4.

12. The use of a polymer as claimed in any of claims 1 to 4 as a photoresist.

13. The use of a polymer as claimed in any of claims 1 to 4 in stereolithography.

14. The use of a polymer as claimed in any of claims 1 to 4 for producing printing plates.

15. The use of a polymer as claimed in any of claims 1 to 4 for producing micromoldings.

16. The use of a polymer as claimed in any of claims 1 to 4 for producing components for microelectronics.

## Revendications

1. Polymère pouvant être obtenu par polymérisation ou copolymérisation de dérivés du 2,7-dioxa-bicyclo[3.2.1]octane de formule 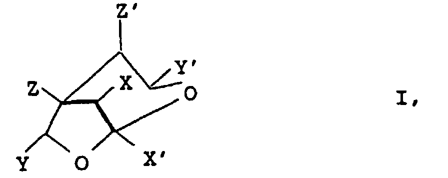 dans laquelle X, X', Y, Y', Z et Z' représentent indépendamment les uns des autres, un reste hydrocarboné en C₁-C₂₀ ou un atome d'hydrogène.

2. Polymère selon la revendication 1, contenant 0,05 à 100% en poids des composés de formule I en tant que monomère ou comonomère.

3. Polymère selon la revendication 1 ou 2, où au moins quatre des variables X, X', Y, Y', Z et Z' représentent un atome d'hydrogène dans la formule I.

4. Polymère selon l'une quelconque des revendications 1 à 3, où toutes les variables X, X', Y, Y', Z et Z' représentent un atome d'hydrogène et où il s'agit donc du 2,7-dioxa-bicyclo[3.2.1]octane.

5. Procédé de préparation de polymères selon l'une quelconque des revendications 1 à 4, caractérisé en ce que des composés de formule I sont polymérisés de façon cationique.

6. Procédé selon la revendication 5, caractérisé en ce que la polymérisation cationique est initiée de façon photochimique.

7. Utilisation de polymères selon l'une quelconque des revendications 1 à 4 pour la préparation de revêtements et de corps moulés.

8. Revêtements et corps moulés, pouvant être obtenus par utilisation de polymères selon l'une quelconque des revendications 1 à 4.

9. Procédé de préparation de corps moulés ou de revêtements structurés, caractérisé en ce que les revêtements et les corps moulés sont constitués au moins en partie de polymères selon l'une quelconque des revendications 1 à 4 et en ce qu'une structuration par dépolymérisation du polymère est effectuée.

10. Procédé selon la revendication 9, caractérisé en ce que la dépolymérisation est effectuée au moyen d'une lumière riche en énergie en présence d'un acide de Brönstedt, c'est à dire d'un acide donnant des protons.

11. Corps moulés ou revêtements structurés pouvant être obtenus en utilisant un polymère selon l'une quelconque des revendications 1 à 4.

12. Utilisation de polymères selon l'une quelconque des revendications 1 à 4 en tant que résine photosensible.

13. Utilisation de polymères selon l'une quelconque des revendications 1 à 4 pour la stéréolithographie.

14. Utilisation de polymères selon l'une quelconque des revendications 1 à 4 pour la fabrication de plaques d'impression.

15. Utilisation de polymères selon l'une quelconque des revendications 1 à 4 pour la fabrication de micro-corps moulés.

16. Utilisation de polymères selon l'une quelconque des revendications 1 à 4 pour la fabrication de composants pour la micro-électronique.
